# EUROPEAN PATENT SPECIFICATION

(11) **EP 0 333 722 B1**
(45) Date of publication and mention of the grant of the patent: **10.03.1993**
(21) Application number: 87907251.0
(22) Date of filing: 13.11.1987
(51) Int. Cl.: B32B 27/10, H05K 3/34, B23K 35/22

(54) **SHEET MATERIAL COATED WITH PRESSURE-SENSITIVE ADHESIVE**
MIT DRUCKEMPFINDLICHEM HAFTMITTEL GESTRICHENE BAHN
MATERIAU EN FEUILLE REVETU D'UN ADHESIF SENSIBLE A LA PRESSION

(30) Priority: 13.11.1986 GB 8627135
(43) Date of publication of application: 27.09.1989
(73) Proprietor: DRG (UK) LIMITED, Boreham Wood, Hertfordshire WD6 1RU (GB)
(72) Inventor: HIGGINSON, Rodney, Boreham Wood Hertfordshire WD6 1RU (GB)
(74) Representative: Clifford, Frederick Alan
(86) International application number: GB8700811
(87) International publication number: WO8803477

(56) References cited:
- DE-A- 1 213 991
- GB-A- 819 105
- GB-A- 919 065

## Description

This invention relates to a sheet material coated with a pressure-sensitive adhesive, usually in a tape form and referred to hereafter as "tape" for convenience of description unless otherwise required by the context.

Pressure sensitive adhesive tape is a well known article of commerce, and consists essentially of a backing covered on one or both faces with a tacky, that is to say, pressure sensitive, adhesive polymeric composition. For convenience the tape is usually sold wound into spirals. To prevent adhesion between the successive turns of such spirals an interposed release strip, or a release coat on the tape backing is used. Refinements of structure of such a tape include primer coats between the backing and the adhesive surface: laminated backing; special purpose backing such as metallised or electrically-insulating backing: water resistant backings or adhesives: and so.

The present invention relates to a removable pressure sensitive adhesive tape designed to be hand-tearable and to provide resistance to heat, chemicals and water. While, as will become more apparent from below, such tape has a number of potential uses it is particularly designed for and useful as a masking tape for portions of a printed circuit board (PCB) during soldering by the so called "air-level" soldering process.

Air-level soldering of a printed board single or double-sided involves passing the board through an aqueous chemical cleaning spray (such as aqueous Hcl/FeCl₂ to clean copper surfaces) followed by a water wash and warm air drying. The board is then coated with flux before being totally immersed vertically beneath the surface of a bath of molten solder at around 235°C-260°C for a period of time from 1-15 seconds, so as to connect by solder adjacent or contiguous components. Thereafter, the printed circuit board is removed and the excess solder is blown off and blown out of any through holes, by air knives on both sides of the board. Subsequently, the soldered printed circuit board is subjected to one or more aqueous washing stages before warm air drying.

Typically, however, there are some areas or components on the printed circuit board which should be protected from the solder bath. Conventionally these are masked off by a masking tape, that is to say, a specialised pressure-sensitive adhesive tape applied over the component area and removed, together with the adhesive layer, after the washing stage. The tape is required to resist and remain in place during all the separate parts of the process
(a) the aqueous chemical cleaning,
(b) the soldering flux application,
(c) the temperature conditions of the soldering bath, for a specified time,
(d) any mechanical dislodgement, especially at the edges, by the air knife,
(e) the aqueous washing stages.

One known form of masking tape meets the criteria by using a polyimide as the backing sheet. Polyimide is well known as a heat-resistant polymer and, like most polymers, is resistant to water. It also forms a suitable backing for a pressure-sensitive adhesive. However, its performance is generally poor, the tape failing because the adhesive mass on the standard products is too low to give a good seal and prevent lifting by the air knife. It is also very expensive.

Another proposal for such a masking-tape structure attempts to use cheaper materials in the form of a laminate.

Kraft paper is resistant to (that is to say preserves its composition and dimensions at) the temperature indicated for the one to fifteen seconds time scale. It is however completely disintegrated by water. If it is loaded by a rubber latex to an extent that does not affect heat resistance it becomes somewhat more water-resistant but even then it is detrimentally affected by the aqueous chemicals and water.

Polyethylene sheet is fully water-resistant but softens and distorts under such temperature conditions as set forth above.

However, a laminate of the two materials does have improved properties over either individual material. In practice, to form such a laminate, the latex-impregnated kraft paper is covered on both surfaces with pressure-sensitive adhesive and then fed to a roller together with a sheet of polyethylene film at one surface. Base coats, and primer coats, between the adhesive layers and their substrate or overlying polymer, and of a conventional nature, can be used if desired. Tape of such cheaper composite material, that is to say (adhesive-optional base coat-impregnated kraft paper-optional base coat-adhesive-an optional primer-polyethylene-optional release coat to permit spiral winding) has the advantages that the heat-resistant paper does stabilise the facing polymer to some extent and that the facing polymer does protect the paper against aqueous chemical washing again to some extent.

However, this laminated material does not perform uniformly well. There is still a tendency for the heat from the solder immersion to cause the polymer covering to shrink back and then curl away from the edges of the paper tape. The use of an air-knife on the solder can increase the extent of delamination of the masking tape. There is accordingly, a tendency for the tape to lift at these edge locations with consequent ingress of solder under the edge of the tape. As a consequence solder is deposited on the masked area of the printed circuit board when the masking tape is pulled off.

The present invention sets out to produce an improved laminated material more resistant to the disadvantages indicated, using a different and simpler manufacturing technique.

In one aspect the invention consists in a laminate comprising a latex-impregnated kraft paper on one face of which is located a pressure sensitive adhesive layer and on the other face of which is located a film of polymer which has directly adhered to the said face from the molten state.

The impregnating latex can be any conventional latex known in the art, and impregnated kraft papers are in themselves well known articles of commerce. Typically, the total weight of the impregnated paper will lie between 40 and 150 grams per square metre.

The kraft paper itself can be a flat paper or can be creped. Crepe paper handles better when placing to an accurate line for masking purposes, and is also more conformable to the small irregularities in the underlying surface.

The pressure-sensitive adhesive can also be of any known type, although a degree of heat resistance is preferable. Thus, for example a rubber/resin-based pressure sensitive adhesive is generally preferable.

The polymer is preferably a polyolefin and most preferably a polyethylene in amounts of e.g. 10-50 g/m². Polyolefins such as polyethylene are capable of bonding when molten directly to the face of the latex and impregnated paper, although it is also within the scope of the invention to carry out a previous preparation stage on this base by the use of a primer material. A typical primer material is a polyethylene/imine derivative. This should not be confused with the provision of an adhesive layer, since no actual adhesive is applied to bond the polymer to the loaded paper. An additional previous preparation of the impregnated paper is to treat the surface by corona discharge immediately prior to applying the polymer.

The laminate of the present invention may also comprise various conventional base coats e.g. between the adhesive and the paper. Moreover, a release material such as a silicone or the like can be applied to the free surface of the polymer. This is particularly valuable if the laminate is provided in a strip form for winding into a spiral of tape.

In another aspect the invention consists of a method of producing a laminate as described above, in which the latex impregnated kraft paper, optionally treated with a primer coat and/or by corona discharge, is fed at the relevant surface past a slit extrusion die to which is supplied a molten polymer, such as a polyolefin and most preferably polyethylene. Typically, the polymer is extruded at a weight of from 10 to 50 grams per square metre. An adhesive layer can be applied to the other face of the kraft paper, and the laminated sheet can thereafter be split into strips and wound into a spiral, optionally with the interposition of the release strip or with the use of a release coating upon the free polymer surface.

In a yet further aspect the invention consists in a method of air level soldering of printed circuit boards in which a portion of the board is masked by a laminate material as described above.

As will be apparent from the above description, an important feature of this invention is the use of molten polymer and its direct adhesion to the kraft paper substrate, optionally with the use of a prior preparation stage involving a primer coat, but in any case avoiding the presence of a definite adhesive layer. The advantageous characteristics of such a laminate as described above, i.e. resistance to delamination of the polymer under teat stress and to subsequent attack on the paper layer in the aqueous washing stages, is surprising and could not have been predicted from the known performance of the existing material which has built up from solid film and conventional adhesives. Also, we have found that the absence of a separate adhesive layer means that a thinner, and hence more conformable, masking tape can be produced, with less of a tendency to accummulate "ridges" of solder marking the edge of the tape.

The invention is to be distinguished from the known packaging tape which is based on non-impregnated kraft paper with a polyethylene film on one side and adhesive on the other. A packaging tape is in no way designed to resist temperature, or to resist anything more than small or casual contact with moisture. Also, it has no conformality requirements.In packaging tapes, therefore, the kraft is not impregnated, and merely provides a base for the spreading of adhesive. It has little internal strength, and the polyethylene provides a good tensile strength to the laminate. Tensile strength however is not of major importance with a masking tape, since the context of use is totally different. Any attempt to use the known packaging tape as masking tape would be immediately unsucessful because of attack of liquid onto the unreinforced and unimpregnated paper.

The invention will be further described with reference to the accompanying drawings, in which:-
Figure 1 shows in diagrammatic cross-section of a masking tape in accordance with the prior art, and
Figure 2 shows a diagrammatic cross-section of a masking tape in accordance with the present invention.

In each figure of drawing layers shown in section are of course not in any relative scale. For convenience, the essential layers of each embodiment have been shown in relatively thick layers and the conventional optional layers (primers, base coats, or release coatings) have been shown in thin layers.

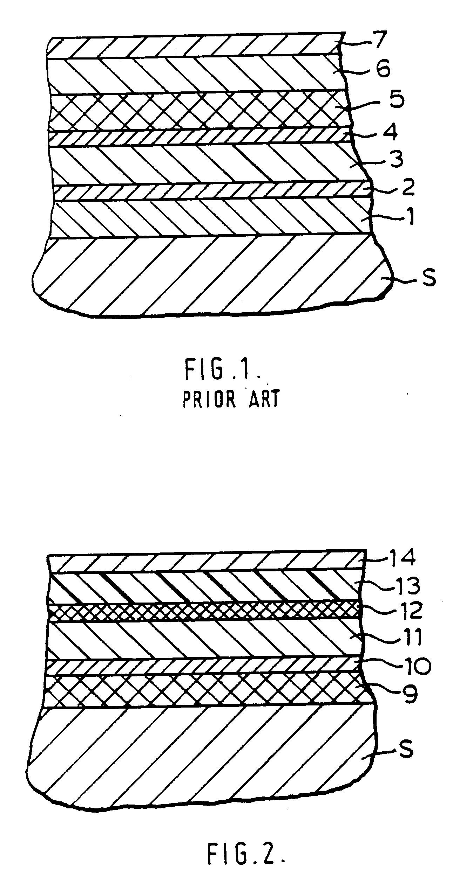

Figure 1 shows a prior art tape adhering to a substrate S. It consists of a layer 1 of pressure-sensitive adhesives an optional base coat 2, a latex-impregnated kraft paper 3, another optional base coat 4, a second pressure sensitive adhesive layer 5 equivalent to layer 1, a layer of adhesive polymer film 6, andan optional release layer 7.

When used as a masking tape in the air-level soldering process the above form of tape gives imperfect results since the film 7 can distort and any distortions are made worse by the air knife. The consequence is that the tape lifts at the edge in the solder both allowing ingress of the solder on to the masked area.

Figure 2 shows a tape according to the invention on a substrate S.

The pressure sensitive adhesive layer 9, as before, can be of any known type although some degree of heat resistance is obviously preferred. Rubber resin adhesive systems of heat-resistance properties are veil established.

Such adhesive possibly with use of a base coat 10 of known composition and function is located on one face of kraft paper 11, impregnated with a conventional latex (again as well known per se) to a total weight of for example 40 to 150 grams per square metre.

On the paper is optionally applied a primer coat of, for example, a polyethylene/imine derivative, (or the paper is treated by corona discharge) and over this which is not of itself adhesive is directly applied a melt-extruded layer preferably 10 - 50 grams per square metre of polyethylene 13. If desired this layer can be coloured.Optional release coat 14 is located as shown before with reference 7.

The material as shown has a significant improved performance as a masking tape in air level soldering of printed circuit boards. The reason for this is not fully known; whether the internal film structure (e.g. crystallite sizes, flow stresses) is advantageously different as between adhered film and self-adhered melt, or whether a paper/polymer direct bond is an improvement in the circumstances over the paper/adhesive/polymer bond is unclear. The polymer is being used near the limit of its solidified state and the improved results obtained were therefore not to be predicted.

## Claims

1. A laminate comprising a latex-impregnated kraft paper (11) on one face of which is located a pressure sensitive adhesive layer (9) and on the other face of which is located a film (13) of polymer characterised in that the said film has adhered without the presence of an adhesive layer to the said face from the molten state.

2. A laminate as claimed in claim 1 wherein the impregnated kraft paper (11) weighs from 40 to 150 grams per square metre.

3. A laminate as claimed in claim 1 in which the impregnated kraft paper (11) is a crepe paper.

4. A laminate as claimed in claim 1 in which the polymer of film (13) is a polyolefin.

5. A laminate as claimed in claim 4 in which the polymer of film (13) is polyethylene.

6. A laminate as claimed in claim 1 or 4 in which from 10 to 50 grams per square metre of polymer of film (13) is present.

7. A laminate as claimed in claim 1 or 4 characterised by further comprising at least one base coat (10) between the adhesive and the paper, and/or at least one release material (14) applied to the free surface of the polymer.

8. A method of producing a laminate as claimed in claim 1 or 4 in which a latex-impregnated kraft paper (11) is fed at one face thereof past a slit extrusion die to which is supplied a molten polymer of film (13) and a layer of pressure-sensitive adhesive (9) is applied to the other face, characterised in that the molten polymer is applied to the paper (11) without the use of an adhesive layer.

9. A method as claimed in claim 8 in which a primer coat (12) and/or a corona discharge treatment is applied to the said one face of the latex impregnated kraft paper (11) prior to contact thereof with molten polymer of film (13).

10. A method as claimed in claim 8 or 9 in which an extruded layer of polymer of film (13) of from 10 to 50 grams per square metre is applied to the latex-impregnated kraft paper (11).

11. A method of air-level soldering of printed circuit boards in which a portion of the board is masked by a laminate as claimed in claims 1 or 4 during soldering.

## Patentansprüche

1. Laminat, das ein mit Latex getränktes Kraftpapier (11) umfaßt, bei dem auf eine Seite eine druckempfindliche Kleberschicht (9), und auf die andere Seite ein Polymerfilm (13) aufgebracht ist, dadurch gekennzeichnet, daß dieser Polymerfilm aus dem geschmolzenen Zustand ohne eine Kleberschicht aufgebracht wurde.

2. Laminat gemäß Anspruch 1, wobei das getränkte Kraftpapier (11) ein Gewicht zwischen 40 und 150 Gramm pro Quadratmeter aufweist.

3. Laminat gemäß Anspruch 1, bei dem das getränkte Kraftpapier (11) ein Kreppapier ist.

4. Laminat gemäß Anspruch 1, bei dem das Polymer des Films (13) ein Polyolefin ist.

5. Laminat gemäß Anspruch 4, bei dem das Polymer des Films (13) Polyethylen ist.

6. Laminat gemäß Anspruch 1 oder 4, bei dem das Polymer des Films (13) ein Gewicht zwischen 10 und 50 Gramm pro Quadratmeter aufweist.

7. Laminat gemäß Anspruch 1 oder 4, dadurch gekennzeichnet, daß es außerdem mindestens eine Grundschicht (10) zwischen dem Kleber und dem Papier, und/oder mindestens ein auf die freie Oberfläche des Polymers aufgebrachtes Schutzmaterial (14) aufweist.

8. Verfahren zum Herstellen eines Laminats gemäß Anspruch 1 oder 4, bei dem ein mit Latex getränktes Kraftpapier (11) mit einer Seite an einer Schlitzextrusionsdüse vorbeigeführt wird, der ein geschmolzenes Polymer des Films (13) zugeführt wird, und eine Schicht aus druckempfindlichem Kleber (9) auf die andere Seite aufgebracht wird, dadurch gekennzeichnet, daß das geschmolzene Polymer ohne eine Kleberschicht auf das Kraftpapier (11) aufgebracht wird.

9. Verfahren gemäß Anspruch 8, bei dem diese eine Seite des mit Latex getränkten Kraftpapiers (11) mit einer Grundierung (12) beschichtet wird und/oder einer Koronaentladungsbehandlung unterworfen wird, bevor sie mit dem geschmolzenen Polymer des Films (13) in Berührung gebracht wird.

10. Verfahren gem&B Anspruch 8 oder 9, bei dem eine extrudierte Schicht aus dem Polrner des Films (13) mit einem Gewicht zwischen 10 und 50 Gramm pro Quadratmeter auf das mit Latex getrankte Kraftpapier (11) aufgebracht wird.

11. Verfahren zum Tauchloten von gedruckten Leiterplatten, bei dem ein Teil der Lelterplatte während des Lotens mit einem Laminat gemäß Anspruch 1 oder 4 abgedeckt wird.

## Revendications

1. Un stratlfié comprenant un papier kraft imprégné de latex (11), sur une face duquel se trouve une couche adhèsive sensible à la pression (9) et sur l'autre face duquel se trouve un film (13) de polymère, caractérisé en ce que ledit film a adhéré en l'absence d'une couche adhésive à ladite face dans son état fondu.

2. Un stratifié selon la revendication 1, dans lequel le papier kraft imprégné (11) a un poids compris entre 40 et 150 grammes par mètre carré.

3. Un stratifié selon la revendication 1, dans lequel le papier kraft imprégné (11) est un papier crêpe.

4. Un stratiflé selon la revendication 1, dans lequel le polymère du film (13) est un polyoléfine.

5. Un stratlfié selon la revendication 4, dans lequel le polymère du film (13) est du polyéthylène.

6. Un stratifié selon les revendications 1 ou 4, dans lequel il y à entre 10 à 50 grammes par mètre carré de polymère du film (13).

7. Un stratifié selon les revendications 1 ou 4, caractérisé en ce qu'il comprend en outre au moins un revêtement de base (10) entre l'adhésif et le papier, et/ou au moins un matériau de séparation (14) appliqué sur la surface libre du polymère.

8. Un procédé de production d'un stratifié selon les revendicatlons 1 ou 4, dans lequel un papier kraft imprégné de latex (11) est alimenté sur une face de celui-ci le long d'une filière d'extrusion droite plate, à laquelle est amené un polymère fondu du film (13), une couche d'un adhésif sensible à la pression (9) étant appliquée sur l'autre face, caractérisé en ce que le polymère fondu est appliqué sur le papier (11) sans l'utilisation d'une couche adhésive.

9. Un procédé selon la revendication 8, dans lequel un revêtement de fond (12) et/ou un traitement de décharge en corona est appliqué sur ladite une face du papier kraft imprégné de latex (11) avant sa mise en contact avec le polymère fondu du film (13).

10. Un procédé selon les revendications 8 ou 9, dans lequel une couche extrudée du polymère du film (13), de 10 à 50 grammes par mètre carré, est appliquée sur le papier kraft imprégné de latex (11).

11. Un procédé de brasage au trempe de plaquettes de circuits imprimés, dans lequel une partie de la plaquette est masquée par un stratifié selon les revendications 1 ou 4 pendant le brasage.
